# EUROPEAN PATENT APPLICATION

(11) **EP 1 635 221 A1**
(43) Date of publication of application: **15.03.2006**
(21) Application number: 05019873.8
(22) Date of filing: 13.09.2005
(51) Int. Cl.: G03F 7/16, B41F 7/30, F24F 6/12

(54) **Method and apparatus for conditioning moisture of object**

(30) Priority: 13.09.2004 JP 2004265426
(71) Applicant: FUJI PHOTO FILM CO., LTD., Minami-Ashigara-shi, Kanagawa (JP)
(72) Inventor: Hayashi, Kenji, Shizuoka (JP); Hashigaya, Manabu, Shizuoka (JP)
(74) Representative: HOFFMANN EITLE

(57) **Abstract**

There are provided a moisture conditioning method and a moisture conditioning apparatus (34, 50, 60) which enable the moisturizing of a coating film (14A) in a short time and at high efficiency, thereby improving productivity, and besides, do not require an increase in the path length of the moisture conditioning zone (26), thereby contributing to cost saving and space saving. When moisture conditioning a coating film (14A) having been applied onto a substrate (14) by allowing the coating film (14A) to stand in or pass through a moisture conditioning zone (26) where humidity is controlled by spraying water, the water to be sprayed in the moisture conditioning zone (26) is made into fine water particles before being sprayed by applying a high voltage or a magnetic force to the water using a moisture conditioning apparatus (34, 50, 60).

## Description

### BACKGROUND OF THE INVENTION

### 1. Field of the Invention

The present invention relates to a method and an apparatus for conditioning the moisture of an object to be moisture conditioned, in particular, to a technique for conditioning the moisture of an overcoat layer, which has been applied onto a photopolymerizable layer (photosensitive layer) when producing a photopolymerizable lithographic plate.

### 2. Related Art

In the production of a photopolymerizable lithographic plate that includes an overcoat layer containing, as a main component, a water-soluble polymer having hydrogen bonding groups, improving sensitivity is a key factor, and thus, there have been conducted research and development of a number of photosensitive systems utilizing radical polymerization, which is advantageous in improving sensitivity. However, since radical polymerization systems are susceptible to polymerization inhibition by oxygen, devices have been thought out to increase the polymerization efficiency. For example, an overcoat layer containing polyvinyl alcohol (PVA), as a main component, and having excellent oxygen barrier properties is provided onto the photopolymerizable layer. In this overcoat layer, if its oxygen permeating rate is too high, the resultant photopolymerizable lithographic plate has a lower sensitivity, whereas if the oxygen permeating layer is too low, the resultant photopolymerizable lithographic plate has an abnormally increased sensitivity, which may undesirably result in poor development, stains or residual film. The oxygen barrier properties of the overcoat layer are largely affected by the moisture content of the same, and thus, it is important to control the moisture content properly. The moisture content of the overcoat layer is controlled by first applying the overcoat layer onto a photopolymerizable layer and then allowing the overcoat layer having been applied onto the photopolymerizable layer to stand in or pass through a constant-temperature/constant-humidity moisture conditioning zone.

However, when moisture conditioning the overcoat layer having been applied onto a belt-like substrate by allowing the same to pass through a moisture conditioning zone while continuously conveying the belt-like substrate, the amount of moisture fed to the overcoat layer depends on the temperature/humidity conditions of the moisture conditioning zone and the residence time of the substrate in the moisture conditioning zone. Accordingly, when increasing the substrate-conveying speed aiming at a productivity increase, it is necessary to enhance the moisture-conditioning performance of the moisture conditioning zone by, for example, increasing the path length of the moisture conditioning zone. However, if there is no space for increasing the moisture conditioning zone, the above measure cannot be adopted. Thus, to increase the substrate conveying speed while avoiding increasing the path length of the moisture conditioning zone, a technique is required which enables the moisturizing of the overcoat layer in a short time and at high efficiency. The same is true for the case where moisture conditioning of an object to be moisture conditioned is performed by allowing the object to be moisture conditioned to stand in a moisture conditioning zone.

Conventional techniques for moisturizing an object to be moisture conditioned include, for example, those disclosed in Japanese Patent Application Laid-Open Nos. 6-257093, 2000-42030, 2003-145650 and 2000-264664. Japanese Patent Application Laid-Open No. 6-257093 discloses a technique for moisture conditioning paper in which the moisture conditioning is carried out by water application and heating. Japanese Patent Application Laid-Open No. 2000-42030 discloses a technique in which moisture conditioning is carried out by making water into fine water particles using ultrasonic wave. Japanese Patent Application Laid-Open No. 2003-145650 discloses a technique for moisture conditioning corrugated board sheets in which moisture conditioning is carried out by controlling the amount of heating. And Japanese Patent Application Laid-Open No. 2000-264464 discloses a technique for moisturizing sheets.

### SUMMARY OF THE INVENTION

Although the above described techniques, which are disclosed in Japanese Patent Application Laid-Open Nos. 6-257093, 2000-42030, 2003-145650 and 2000-264664, are typical techniques for moisture controlling an object to be moisture controlled, they are not satisfactory ones in terms of moisturizing an object to be moisture conditioned in a short time and at high efficiency.

So far, problems with moisture conditioning techniques have been described taking the case of the overcoat layer of a photopolymerizable lithographic plate; however, the application of the moisture conditioning method or apparatus of the present invention is not intended to be limited to such an overcoat layer. The same problems also arise in moisture conditioning of paper (e.g. corrugated board), resin film and the like, and the present invention is also applicable when an object to be moisture conditioned is paper, resin film or the like.

The present invention has been made in the light of the above described situation. Accordingly, the object of the present invention is to provide a moisture conditioning method and apparatus for moisture conditioning an object to be moisture conditioned which enable the moisturizing of the object in a short time and at high efficiency, thereby realizing a productivity increase, and besides, which does not require an increase in the path length of a moisture conditioning zone, whereby contributing to cost saving as well as space saving.

To accomplish the above described object, a first aspect of the present invention is a method for conditioning the moisture of an object to be moisture conditioned by allowing the object to be moisture conditioned to stand in or pass through a moisture conditioning zone where humidity is controlled by spraying water, comprising the steps of: making the water to be sprayed into fine water particles, and spraying the water made into fine water particles in the moisture conditioning zone.

According to the first aspect of the present invention, the water to be sprayed in the moisture conditioning zone penetrates into the object to be moisture conditioned more easily because it is in the form of fine water particles, thereby being capable of moisturizing the object to be moisture conditioned in a short time and at high efficiency. This makes it possible not only to increase productivity, but also to avoid increasing the path length of the moisture conditioning zone, thereby contributing to cost saving as well as space saving. The moisture conditioning zone can be not only moisture conditioned, but also temperature conditioned.

A second aspect of the present invention is the moisture conditioning method according to the first aspect of the present invention, wherein the water having been made into fine water particles has a particle size of 2.0 µm or less. Making the water to be sprayed into fine water particles having a particle size of 2.0 µm or less makes it much easier for the water to penetrate into the object to be moisture conditioned.

To accomplish the above described object, a third aspect of the present invention is a method for conditioning the moisture of an object to be moisture conditioned by allowing the object to be moisture conditioned to stand in or pass through a moisture conditioning zone where humidity is controlled by spraying water, comprising the steps of charging the water to be sprayed positively or negatively, charging the object to be moisture conditioned opposite to the water to be sprayed or making to have a potential of 0 (being grounded).

According to the third aspect of the present invention, since the water to be sprayed and the object to be moisture conditioned are charged opposite to each other, the water to be sprayed is attracted to the object to be moisture conditioned, which makes it possible to moisture the object to be moisture conditioned in a short time and at high efficiency. In this case, the object to be moisture conditioned is allowed to have a potential of 0 (be grounded). Charging the water to be sprayed and the object to be moisture conditioned in reverse enables a productivity increase, and at the same time, contributes to cost saving as well as space saving because to do so does not require increase in the path length of the moisture conditioning zone. For example, a negatively charged water mist is formed in such a manner as to charge the space, where water is to be sprayed, negatively by applying a high voltage to the air or utilizing Lenard's effect and spray water in the space. Applying a high voltage to water allows the water not only to be charged, but also to be made into an ultra fine mist. On the other hand, the object to be moisture conditioned is charged positively using corona discharge equipment etc. Thus, the attraction effect, which is produced by charging the water to be sprayed and the object to be moisture conditioned, coupled with the penetration effect, which is produced by making the water to be sprayed into fine water particles, makes it possible to moisturize the object to be moisture conditioned in a much shorter time and at much higher efficiency.

A fourth aspect of the present invention is the moisture conditioning method according to the third aspect of the present invention, wherein the above described water is made into fine water particles at the time of or before being charged.

A fifth aspect of the present invention is the moisture conditioning method according to the first, second or fourth aspect of the present invention, wherein the above described water is made into fine water particles by applying a voltage as high as 1000 V to 20000 V to the water. The fifth aspect of the present invention is one example of methods for making water into fine water particles in which a voltage as high as 1000 V to 20000 V is applied to the water.

A sixth aspect of the present invention is the moisture conditioning method according to the first, second or fourth aspect of the present invention, wherein the above described water is made into fine water particles by applying a magnetic force of 500 Gauss or more to the water. The sixth aspect of the present invention is one example of methods for making water into fine water particles in which a magnetic force of 500 Gauss (0.05 millitesla) or more is applied to the water. The application of such a magnetic force makes it possible to break the clusters of water, thereby making the water into fine water particles.

A seventh aspect of the present invention is the moisture conditioning method according to any one of the first to sixth aspects of the present invention, wherein the above described object to be moisture conditioned is an overcoat layer containing PVA as a main component which is applied onto a photosensitive material when producing a photopolymerizable lithographic plate. When the object to be moisture conditioned is an overcoat layer containing PVA, as a main component, which is applied onto a photosensitive material when producing a photopolymerizable lithographic plate, the present invention works very effectively as a technique for moisture conditioning the overcoat layer to a given moisture content in a short time.

To accomplish the above described object, an eighth aspect of the present invention is an apparatus for conditioning the moisture of an object to be moisture conditioned by allowing the object to be moisture conditioned to stand in or pass through a moisture conditioning zone where humidity is controlled by spraying water, wherein the apparatus comprises a spraying device which sprays water in the above described moisture conditioning zone and a fine water particle-forming device which makes the water to be sprayed into fine water particles.

The eighth aspect of the present invention is an apparatus which makes the water to be sprayed in the moisture conditioning zone into fine water particles, thereby making it easy for the water to be sprayed to penetrate into the object to be moisture conditioned, and hence making it possible to moisturize the object to be moisture conditioned in a short time and at high efficiency.

A ninth aspect of the present invention is the moisture conditioning apparatus according to the eighth aspect, characterized in that the above described fine water particle-forming device is a high-voltage applying device which applies a high voltage to the water in the form of a mist which has been sprayed by the above described spraying device.

The ninth aspect of the present invention is the apparatus which makes the water to be sprayed into fine water particles, wherein preferably the voltage applied to the water is as high as 1000 V to 20000 V.

A tenth aspect of the present invention is the moisture conditioning apparatus according to the eighth aspect, characterized in that the above described fine water particle-forming device is a magnetic force applying device which applies a magnetic force to the water fed to the above described spraying device.

The tenth aspect of the present invention is the apparatus which makes the water before sprayed into fine water particles with a magnetic force applying device, wherein preferably the magnetic force applied to the water is 500 Gauss (0.05 millitesla) or more.

The moisture conditioning method and apparatus for moisture conditioning an object to be moisture conditioned of the present invention enables the moisturizing of an object to be moisture conditioned in a short time and at high efficiency, thereby realizing a productivity increasing, and at the same time, the method and apparatus do not require increasing of the path length of the moisture conditioning zone, thereby contributing to cost saving as well as space saving.

### BRIEF DESCRIPTION OF THE DRAWINGS

Fig. 1 is a production line of a lithographic plate raw material in which the moisture conditioning apparatus for moisture conditioning an object to be moisture conditioned of the present invention is incorporated in its moisture conditioning zone;
Fig. 2 is a schematic diagram of a high voltage-type moisture conditioning apparatus provided in the moisture conditioning zone;
Fig. 3 is a schematic diagram of a magnetization-type moisture conditioning apparatus provided in the moisture conditioning zone;
Fig. 4 is a schematic diagram of a charging-type moisture conditioning apparatus provided in the moisture conditioning zone; and
Fig. 5 is a graph for comparing the moisturizing rates in the moisture conditioning zones provided with moisture conditioning apparatuses of the present invention and the moisturizing rate in a conventional heating/moisturizing zone.

### DETAILED DESCRIPTION OF THE PREFERRED EMBODIMENTS

In the following, preferred embodiments of the moisture conditioning method and apparatus, of the present invention, for moisture conditioning an object to be moisture conditioned will be described in detail with reference to the accompanying drawings.

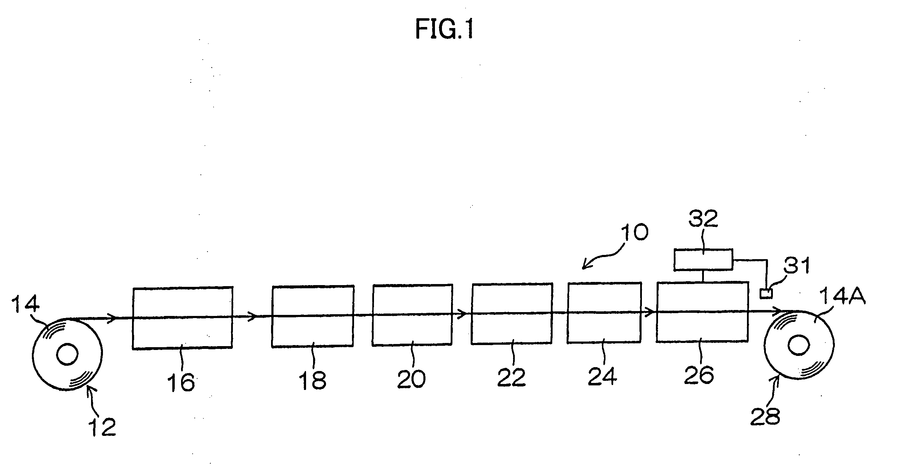

Fig. 1 is a view showing one example of production lines 10 of lithographic plate raw materials which include a moisture conditioning zone incorporating a moisture conditioning apparatus, of the present invention, for moisture conditioning an object to be moisture conditioned. Hereafter, preferred embodiments of the present invention will be described in terms of the production line 10; however, it is to be understood that this is not intended to limit the application of the present invention to the production line 10 of lithographic plate raw materials. The present invention is applicable to all the lines, such as moisturizing lines for production of corrugated board or production of resin films, in which a technique for moisture conditioning an object to be moisture conditioned in a short time and at high efficiency is needed.

As shown in Fig. 1, a continuous substrate 14 wound in a roll is set in a delivery machine 12. The substrate 14 continuously delivered from the delivery machine 12 undergoes surface treatment in a surface-treatment section 16. On the back side of the substrate 14 having been surface treated is formed a back coat layer in a back coat layer-application/drying section 18 and then on the front side of the substrate 14 is formed an undercoat layer in a sub-coat application/drying section 20. Then, on the undercoat layer are formed a photosensitive layer of a phoptopolymerizable composition in a photosensitive layer application/drying section 22 and a overcoat layer containing a water-soluble polymer having hydrogen bonding groups, e.g. PVA (polyvinyl alcohol), as a main component (PVA coating film) in a overcoat layer application/drying section 24 in this order, and at the same time, the crystallinity of the water-soluble polymer contained in the overcoat layer is controlled to fall in a give range. Then, the moisture content of the overcoat layer is controlled to fall in a given range, e.g. in the range of 4 to 8%, in a moisture conditioning zone 26. The moisture content of the overcoat layer undergoes on-line measurement with a moisture analyzer 31, and an air conditioning unit 32 in the moisture conditioning zone 26 controls the temperature/humidity of the overcoat layer moisture conditioning zone so that the moisture content data become constant. Thus, the raw material 14A for a photopolymerizable lithographic plate is produced, and the produced raw material 14A is wound into a wind-up machine 28.

For the substrate 14 used in the present invention, aluminum, which is dimensionally stable, or an alloy thereof (e.g. its alloy with silicon, copper, manganese, magnesium, chromium, zinc, lead, bismuth or nickel) can be used. Usually, conventionally known materials described in Handbook of Aluminum, 4^{th} ed. (Japan Light Metal Association, 1990), such as materials of JIS A 1050, JIS A 1100, JIS A 3103, JIS A 3004, JIS A 3005 and the alloys thereof in which 0.1 wt% or more of magnesium is added to increase the tensile strength, can be used.

For example, when the substrate 14 is an aluminum sheet, usually the aluminum sheet undergoes various types of surface treatment in the surface-treatment section 16, depending on the purpose for which it is used. In a commonly used treatment process, first the surface of the aluminum sheet is cleaned by subjecting the aluminum sheet to degreasing or electropolishing and to desmutting. Then, the aluminum sheet is subjected to mechanical roughening or/and electrochemical roughening to provide the surface with fine irregularities. In some cases, chemical etching and desmutting can sometimes be added when providing the surface with a fine texture. After that, the surface of the aluminum sheet is anodized to increase its abrasion resistance and, if necessary, it undergoes hydrophilization or/and sealing.

In the back coat layer application/drying section 18, the back side of the substrate 14 is provided, depending on the situation, with a coating layer (back coat layer) composed of organic polymer which is for preventing the photosensitive composition layer from being scratched when more than one substrate are stacked one over the other.

In the sub-coat application/drying section 20, the front side of the substrate 14 is coated, depending on the situation, with a coating fluid for an undercoat layer and dried to form an undercoat layer on its surface. As the coating process and conditions in the sub-coat application/drying section 20, the coating process and many of the conditions employed in the application of photosensitive composition layer described later can be used.

In the photosensitive layer application/drying section 22, a coating of a photopolymerizable photosensitive composition is applied onto the undercoat layer and dried to form a photosensitive layer. And in the overcoat layer application/drying section 24, a coating for an overcoat layer is applied onto the photosensitive layer.

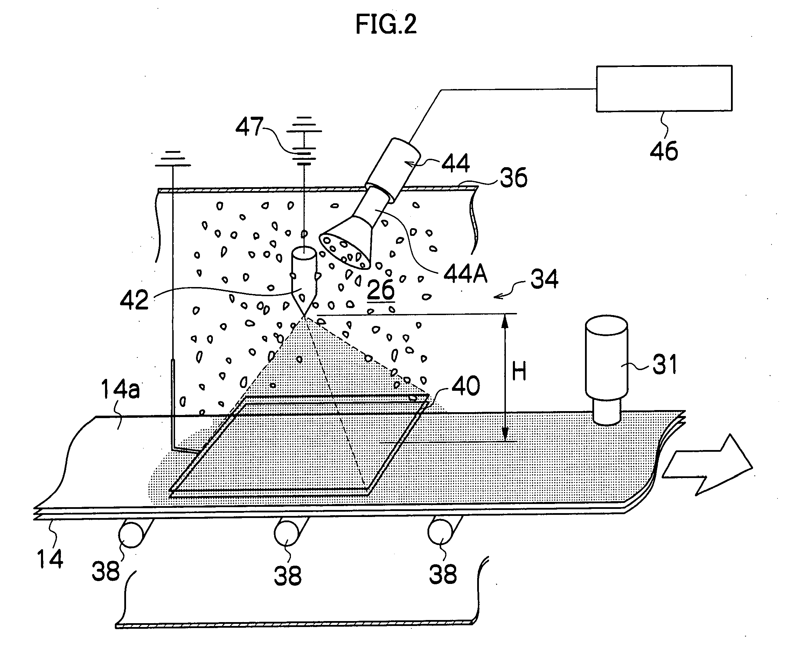

Fig. 2 is a schematic diagram of a moisture conditioning apparatus 34 provided in the moisture conditioning zone 26, which is one example of high voltage-type apparatus which apply a high voltage to the water to be sprayed in the moisture conditioning zone 26 to make the water into fine water particles, thereby accelerating the moisturizing of the overcoat layer.

As shown in Fig. 2, the moisture conditioning zone 26 is enclosed with a tunnel-like casing in which an inlet and an out let for the substrate 14, which is continuously conveyed in the direction shown by the arrow in the figure, are formed. The substrate 14 is conveyed on the pass rollers 38 with its overcoat layer 14a facing up. The high voltage-type moisture conditioning apparatus 34 is made up mainly of: a high voltage applying device consisting of a grounding electrode 40 and a high-voltage electrode 42; mist generating equipment 44; and water feeding equipment 46. Specifically, the grounding electrode 40 formed in a ring is arranged above the overcoat layer 14a in parallel with the substrate 14 and the high-voltage electrode 42 connected to a high-voltage power supply 47 is arranged above the grounding electrode 40. The grounding electrode 40 can take the form of a square, circle, ellipsoid or triangle, instead of a ring. The mist generating equipment 44 is arranged so that its spraying portion 44A can spray water in the space between the high-voltage electrode 42 and the grounding electrode 40 and is connected to the water feeding equipment 46. Thus, the water to be sprayed from the spraying portion 44A passes through a high-voltage electric field formed between the high-voltage electrode 42 and the grounding electrode 40, thereby deriving a large amount of energy from the electric field. When the amount of energy goes beyond the surface tension of the water, the cluster of water is broken and the water having been made into fine water particles reaches the overcoat layer 14a. From the viewpoint of accelerating the breakage of the water cluster, preferably a voltage as high as 1000 V to 20000 V is applied to the water and more preferably a voltage as high as 5000 V to 20000 V. The distance (H) between the high-voltage electrode 42 and the grounding electrode 40 is preferably in the range of 100 to 300 mm and more preferably in the range of 150 to 250 mm. And the particle size of the water having been made into fine water particles is preferably 2.0 µm or less.

On the downstream of the moisture conditioning apparatus 34 relative to the direction in which the substrate is conveyed, a moisture analyzer 31 which measures the moisture of the overcoat layer 14a in a non-contact manner is arranged, and the moisture of the overcoat layer 14a having been moisture conditioned in the moisture conditioning zone 26 is determined.

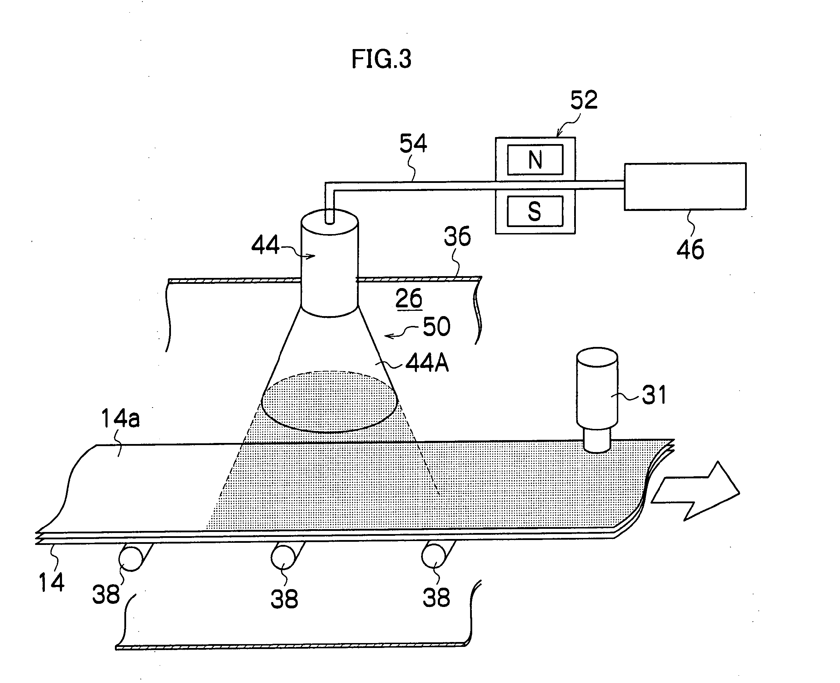

Fig. 3 is a schematic diagram of another moisture conditioning apparatus 50 provided in the moisture conditioning zone 26, which is one example of magnetization-type apparatus which apply a magnetic force to the water to be sprayed in the moisture conditioning zone 26 to make the water into fine water particles, thereby accelerating the moisturizing of the overcoat layer. The same equipment and members as those in Fig. 2 will be described using the same reference numerals.

As shown in Fig. 3, the casing 36 which encloses the moisture conditioning zone 26 is the same as that of Fig. 2. The magnetization-type moisture conditioning apparatus 50 is made up mainly of: mist generating equipment 44; magnetized water generating equipment 52 as a magnetic force applying device; and water feeding equipment 46. Specifically, the spraying portion 44A of the mist generating equipment 44 is provided above the overcoat layer 14a and the mist generating equipment 44 is connected to the water feeding equipment via piping 54. On the midway of the piping 54 is provided magnetized water generating equipment 52. The magnetized water generating equipment 52 generates a strong magnetic field in the piping 54 using the N pole and the S pole arranged so as to face each other across the piping 54. The water flowing through the piping 54 goes across the magnetic field and is provided with a magnetic force, whereby the cluster of the water is broken and the water is made into fine water particles. Preferably, the particle size of the water having been made into fine water particles is 2.0 µm or less. Thus, the water having been made into fine water particles is sprayed from the spraying portion 44A of the mist generating equipment 44 and reaches the overcoat layer 14a. From the viewpoint of accelerating the breakage of the water cluster, preferably a magnetic field as strong as 500 Gauss (0.05 millitesla) or more is applied to the water and more preferably a magnetic field as strong as 800 Gauss (0.08 millitesla).

In Fig. 3 like in Fig. 2, on the downstream of the moisture conditioning apparatus 50 relative to the direction in which the substrate is conveyed, a moisture analyzer 31 which measures the moisture of the overcoat layer 14a in a non-contact manner is arranged, and the moisture of the overcoat layer 14a having been moisture conditioned in the moisture conditioning zone 26 is determined.

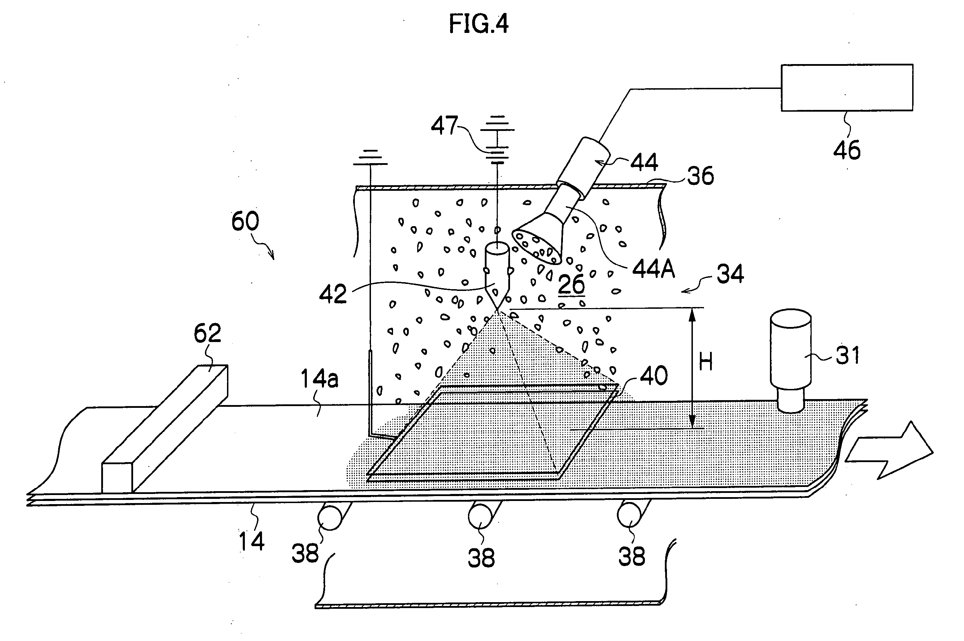

Fig. 4 is a schematic diagram of a moisture conditioning apparatus 60 which charges the water to be sprayed in the moisture conditioning zone 26 negatively while charging the overcoat layer positively. The apparatus is one example of charging-type moisture conditioning apparatus which is capable of charging water while making the water into fine water particles. The same equipment and members as those in Fig. 2 or Fig. 3 will be described using the same reference numerals. When the water is charged negatively, the overcoat layer may be charged positively or have a potential of 0 (be grounded).

As shown in Fig. 4, the casing 36 which encloses the moisture conditioning zone 26 is the same as that of Fig. 2. The charging-type moisture conditioning apparatus 60 is made up mainly of: a positively charging device 62 which charges the overcoat layer before entering the moisture conditioning zone 26 positively; and a negatively charging device which charges the water to be sprayed in the moisture conditioning zone 26 negatively. As the positively charging device, for example, corona discharge equipment is employed. As the negatively charging device, the moisture conditioning apparatus 34 can be used as it is. Specifically, the water to be sprayed in the moisture conditioning zone 26 can be made into fine water particles, while charging the mist consisting of the fine water particles negatively, by first applying a high voltage across the high-voltage electrode 42 and the grounding electrode 40 to charge the space between the high-voltage electrode 42 and the grounding electrode 40 negatively and then spraying water in the moisture conditioning zone from the mist generating equipment 44. As a result, the water to be sprayed from the mist generating equipment 44, which is in the form of fine water particles and has been charged negatively, is attracted to the overcoat layer 14a, which has been charged positively, whereby the moisturizing of the overcoat layer 14a is accelerated. Thus, due to the attraction effect, which is produced by charging the water to be sprayed and the overcoat layer 14a oppositely, coupled with the penetration effect, which is produced by making the water into fine water particles, the moisture conditioning apparatus 60 of Fig. 4 enables the moisturizing of the overcoat layer 14a in a much shorter time and at much higher efficiency. So far, this embodiment has been described taking the case where the moisture conditioning apparatus 60 charges the overcoat layer 14a positively, while charging the water negatively; however, the moisture conditioning apparatus 60 may charge the overcoat layer 14a negatively, while charging the water positively.

In Fig. 4 like in Figs. 2 and 3, on the downstream of the moisture conditioning apparatus 60 relative to the direction in which the substrate is conveyed, a moisture analyzer 31 which measures the moisture of the overcoat layer 14a in a non-contact manner is arranged, and the moisture of the overcoat layer 14a having been moisture conditioned in the moisture conditioning zone 26 is determined.

Each of the moisture conditioning apparatus 34, 50 and 60 of Figs. 2 to 4 has been described taking the case where there is only one moisture conditioning apparatus 34, 50 or 60 in the moisture conditioning zone 26; however, more than one moisture conditioning apparatus 34, 50 or 60 may be provided in the moisture conditioning zone 26, depending on the path length of the moisture conditioning zone 26.

### [Examples]

A PVA coating fluid (a coating fluid containing polyvinyl alcohol as a main component) was applied onto aluminum substrates 14 so that the amount of the coating fluid applied was 2 g/m² to form a PVA coating film (corresponding to the overcoat layer) on the substrates. Each of the substrates with a PVA coating film formed on it was allowed to pass through a moisture conditioning zone 26 in which a high voltage-type, magnetization-type, or charging-type moisture condition apparatus 34, 50 or 60 was provided so that the rates of moisturizing the PVA coating film in the respective cases were compared. The rates of moisturizing the PVA coating film were determined by measuring the moisture content of the PVA coating film vs. the residence time of the substrates in the moisture conditioning zone 26. As the moisture analyzer 31, an infrared moisture analyzer IRM-V manufactured by CHINO CORPORATION was used. In comparative examples, water was sprayed in the moisture conditioning zone 26 by conventional heating/moistening method.

### (Comparative example)

Water heated to 60 to 70°C was sprayed in the moisture conditioning zone 26 with a fan.

### (Example 1)

Water was sprayed in the moisture conditioning zone 26 with a high voltage-type moisture conditioning apparatus 34 of Fig. 2. The voltage applied to the high voltage electrode 42 was 6000 V.

### (Example 2)

Water was charged negatively and sprayed in the moisture conditioning zone 26, while the PVA coating film before entering the moisture conditioning zone 26 was charged positively, with a charging-type- moisture conditioning apparatus 60 of Fig. 4.

### (Example 3)

Water was sprayed in the moisture conditioning zone 26 with a magnetization-type moisture conditioning apparatus 50 of Fig. 3. As the magnetized water generating equipment 52, a ferrite magnet was used. A magnetic force of 3000 Gauss was applied to the water.

In all of the above described comparative example and examples 1 to 3, the temperature in the moisture conditioning zone 26 was kept at 26°C and the humidity at 55% RH.

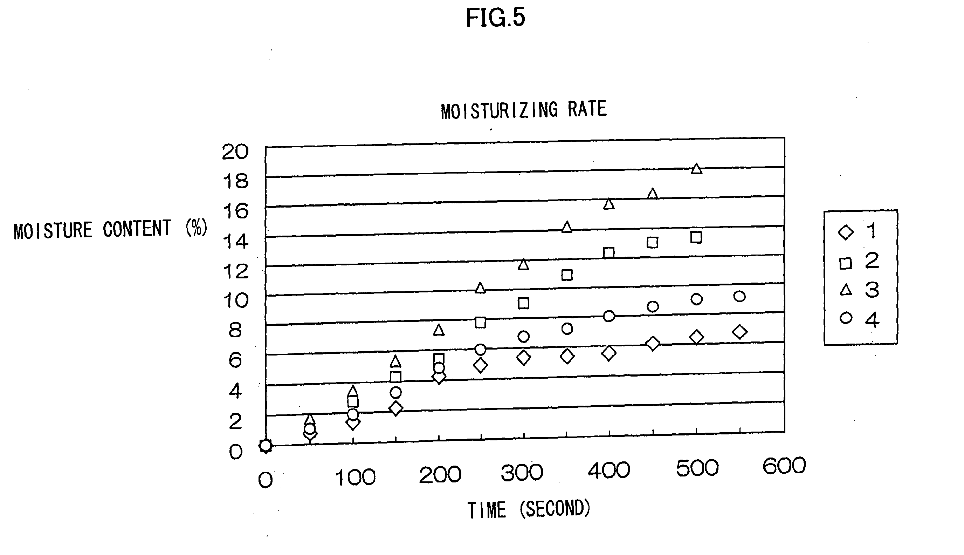

The results are shown in Fig. 5. In Fig. 5, ◇, □, △ and ○ each represent the results of comparative example, example 1, which employed a high voltage-type moisture conditioning apparatus, example 2, which employed a charging-type-moisture conditioning apparatus, and example 3, which employed a magnetization-type-moisture conditioning apparatus. In Fig. 5, the residence time (second) of the conveyed substrate 14 in the moisture conditioning zone 26 is plotted in abscissa and the moisture content (%) of the PVA coating film having been applied onto the substrate 14 in ordinate.

As is evident from Fig. 5, the residence time of the substrate 14 in the moisture conditioning zone 26 until the moisture content of the PVA coating film reached 4% was about 200 seconds for the comparative example, about 150 seconds for example 1, about 120 seconds for example 2 and about 180 seconds for example 3. And the residence time of the substrate 14 in the moisture conditioning zone 26 until the moisture content of the overcoat layer reached 8% was about 260 seconds for example 1, about 220 seconds for example 2 and about 400 seconds for example 3. In contrast, for the comparative example, even if the residence time was increased to 500 seconds or longer, the moisture content of the overcoat layer was increased to 6% or more at the most.

As can be seen from the results, in examples 1 to 3, moisturizing of the PVA coating film could be performed in a shorter time than in the comparative example. In examples 1 and 2, the moisture content of the PVA coating film increased in proportion to an increase in the residence time of the substrate in the moisture conditioning zone. Particularly in example 2, the moisture content increased almost linearly in proportion to an increase in the residence time. The reason better results were obtained in example 2 than in examples 1 and 3 is probably that in example 2, which employed a charging-type moisture conditioning apparatus, when applying a high voltage to water, the water was not only charged negatively, but made into fine water particles, whereby both charging effect and making-water-into-minute-water-particles effect were produced.

As described so far, the present invention enables the moisturizing of the PVA coating film in a short time and at high efficiency, thereby realizing a productivity increase; at the same time, it does not require an increase in the path length of the moisture conditioning zone, thereby contributing to cost saving as well as space saving.

In the above examples, the present invention has been described in terms of the case where the object to be moisture conditioned is a PVA coating film; however, the same results can also be obtained when applying the present invention to the moistening line of corrugated board production or resin film production.

## Claims

1. A method for conditioning the moisture of an object (14A) to be moisture conditioned by allowing the object (14A) to be moisture conditioned to stand in or pass through a moisture conditioning zone (26) where humidity is controlled by spraying water, comprising the steps of:
making the water to be sprayed into fine water particles; and
spraying the water made into fine water particles in the moisture conditioning zone (26).

2. The moisture conditioning method according to claim 1, wherein the water having been made into fine water particles has a particle size of 2.0 µm or less.

3. A method for conditioning the moisture of an object to be moisture conditioned by allowing the object (14A) to be moisture conditioned to stand in or pass through a moisture conditioning zone (26) where humidity is controlled by spraying water, comprising the steps of:
charging the water to be sprayed positively or negatively; and
charging the object (14A) to be moisture conditioned opposite to the water to be sprayed or making to have a potential of 0 (being grounded).

4. The moisture conditioning method according to claim 3, wherein the water is made into fine water particles at the time of or before being charged.

5. The moisture conditioning method according to claim 1, 2 or 4, wherein the water is made into fine water particles by applying a voltage as high as 1000 V to 20000 V to the water.

6. The moisture conditioning method according to claim 1, 2 or 4, wherein the water is made into fine water particles by applying a magnetic force of 500 Gauss or more to the water.

7. The moisture conditioning method according to any one of claims 1 to 6, wherein the object (14A) to be moisture conditioned is an overcoat layer (14A) containing PVA as a main component, which is applied onto a photosensitive layer in the production of a photopolymerizable lithographic plate.

8. An apparatus (34, 50, 60) for conditioning the moisture of an object (14A) to be moisture conditioned by allowing the object (14A) to be moisture conditioned to stand in or pass through a moisture conditioning zone (26) where humidity is controlled by spraying water, comprising:
a spraying device (44, 44A) which sprays water in the moisture conditioning zone (26); and
a fine water particle-forming device (40, 42, 47, 52) which makes the water to be sprayed into fine water particles.

9. The moisture conditioning apparatus (34, 60) according to claim 8, wherein the fine water particle-forming device is a high-voltage applying device (40, 42, 47) which applies a high voltage to the water in the form of a mist which has been sprayed by the spraying device (44, 44A).

10. The moisture conditioning apparatus (50) according to claim 8, wherein the fine water particle-forming device is a magnetic force applying device (52) which applies a magnetic force to the water fed to the spraying device (44, 44A).
